(19) Europäisches Patentamt
European Patent Office
Office européen des brevets

(11) **EP 1 914 915 B1**

(12) **EUROPEAN PATENT SPECIFICATION**

(45) Date of publication and mention of the grant of the patent:
**14.07.2010 Bulletin 2010/28**

(51) Int Cl.:
***H04J 3/06*** (2006.01) ***H04L 7/033*** (2006.01)
***H04N 7/62*** (2006.01)

(21) Application number: **07124129.3**

(22) Date of filing: **27.12.2004**

(54) **Reference Clock Recovery Apparatus and Method**

Vorrichtung und Verfahren zur Rückgewinnung eines Referenztakts

Appareil et procédé de récupération d'horloge de référence

(84) Designated Contracting States:
**AT BE BG CH CY CZ DE DK EE ES FI FR GB GR HU IE IS IT LI LT LU MC NL PL PT RO SE SI SK TR**

(30) Priority: **27.12.2003 KR 20030098302**

(43) Date of publication of application:
**23.04.2008 Bulletin 2008/17**

(62) Document number(s) of the earlier application(s) in accordance with Art. 76 EPC:
**04030845.4 / 1 548 963**

(73) Proprietor: **Electronics and Telecommunications Research Institute**
**Yuseong-Gu**
**Daejon 305-350 (KR)**

(72) Inventors:
- **Kim, Byoung-hak**
  **305-350, Daejon (KR)**
- **Lee, Ho-Jin**
  **305-761, Daejon (KR)**
- **Kim, Ho-Kyom**
  **305-755, Daejon (KR)**
- **Oh, Deock-Gil**
  **302-120, Daejon (KR)**

(74) Representative: **Betten & Resch**
**Patentanwälte**
**Theatinerstrasse 8**
**80333 München (DE)**

(56) References cited:
**US-A1- 2002 003 799** **US-A1- 2003 066 094**
**US-A1- 2003 152 032**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 914 915 B1

Printed by Jouve, 75001 PARIS (FR)

## Description

### Field of Invention

The present invention relates to a reference clock recovery apparatus and method which are capable of accurately and effectively recovering and maintaining a network synchronization reference clock by using a return link channel in a network synchronization system or the like. More particularly, the present invention relates to a reference clock recovery apparatus and method which are capable of maintaining synchronization by using a program clock reference (PCR) in an MPEG-TS of a forward link and a synchronization compensation information on a return link channel for synchronization.

### Description of Prior Art

In general, a timing synchronization must be maintained between a central station and a terminal in a time division multiple access (TDMA) system.

In order to maintain the timing synchronization, a reference clock synchronization is acquired and maintained using a program clock reference (hereinafter, referred to as a PCR) inserted in a moving picture experts group - transport stream (hereinafter, referred to as an MPEG-TS) of a forward link in a satellite communication. However, this method has a problem in that it has a defect in accuracy when maintaining the synchronization for a return link.

In addition, a perfect synchronization between the central station and the terminal means that the central station and the terminal share the same clock source. However, the central station and the terminal cannot share the same clock source in a wireless communication system. That is, if a high-performance GPS clock system is used in the central station and the terminal, a timing synchronization may be achieved, but size and cost of communication terminals are increased.

US 2003/0066094 describes an internal system time clock within an MPEG-2 decoder being synchronized in frequency and optionally in phase, but not in value, to program clock reference time stamps within a received MPEG-2 transport stream. A demultiplexer separating audio and video packets from the transport stream modifies the decoding and presentation time stamps within such packets by at least an offset between the program clock reference time stamp values and the internal system time clock time before forwarding the packets to the audio and video decoders. Discontinuities in the program clock reference time stamp sequence automatically result in a change in the offset, such that the internal system time clock continues to increase monotonically and decoding and presentation time stamps within the packets are not suddenly invalidated.

### Summary of Invention

It is, therefore, an object of the present invention to provide a reference clock recovery apparatus and method which are capable of accurately and effectively recovering and maintaining a network synchronization reference clock by using a PCR in an MPEG-TS of a forward link and a synchronization compensation information on a return link channel for synchronization.

In accordance with an aspect of the present invention, there is provided a reference clock recovery apparatus including: a tuner for receiving a signal modulated at a central station and converting the modulated signal into a digital value; a first frequency difference detector for detecting a frequency difference between the central station and a terminal by using a program clock reference (PCR) value inserted in a moving picture experts group - transport stream (MPEG-TS) outputted from the tuner and a local clock count value of the terminal and tracing a clock frequency of the central station; a first filter for smoothing the detected frequency difference between the central station and the terminal; a second frequency difference detector for causing the terminal to maintain a synchronization to the clock of the central station based on a timing estimation information, which is measured at the central station; a second filter for smoothing the frequency difference between the terminal and the central station, which is calculated by the second frequency difference detector; a switch for selecting an operation of the first frequency difference detector or an operation of the second frequency difference detector; a digital-to-analog converter for converting a digital signal from the switch into an analog signal; an oscillator for receiving an output of the digital-to-analog converter and outputting a desired frequency; a counter for counting the clocks outputted from the oscillator and outputting the count value to the first frequency difference detector; and a channel for transmitting the timing information obtained by the first frequency difference detector through a return link channel for synchronization.

The reference clock recovery apparatus may further include a compensator for compensating for an error occurring when a next synchronization maintaining transmission timing of the terminal is calculated.

In accordance with another aspect of the present invention, there is provided a reference clock recovery method applied to a reference clock recovery apparatus, including the steps of: obtaining a reference synchronization by using a time stamp received from a central station through a forward link; transmitting a synchronization maintaining channel through a return link; receiving a synchronization error estimation information transmitted from the central station by using the transmitted synchronization maintaining channel and performing a synchronization error compensation.

Brief Description of the Drawings

The above and other objects and features of the present invention will become apparent from the following description of preferred embodiments taken in conjunction with the accompanying drawings, in which:

Fig. 1 is a block diagram of a conventional reference clock recovery apparatus;
Fig. 2 is a block diagram showing a conventional reference clock recovery method using a time stamp of a forward link;
Fig. 3 is a block diagram of a reference clock recovery apparatus in accordance with the present invention;
Fig. 4 is a block diagram showing a reference clock recovery method in accordance with an embodiment of the present invention;
Fig. 5 is a timing diagram showing a synchronization acquisition of the central station and the terminal in the reference clock recovery apparatus in accordance with an embodiment of the present invention;
Fig. 6 is a block diagram of a reference clock recovery apparatus in accordance with another embodiment of the present invention; and
Fig. 7 is a detailed diagram of the loop filter in accordance with an embodiment of the present invention

Detailed Description of Invention

Hereinafter, a reference clock recovery apparatus and method in accordance with the present invention will be described in detail referring to the accompanying drawings.

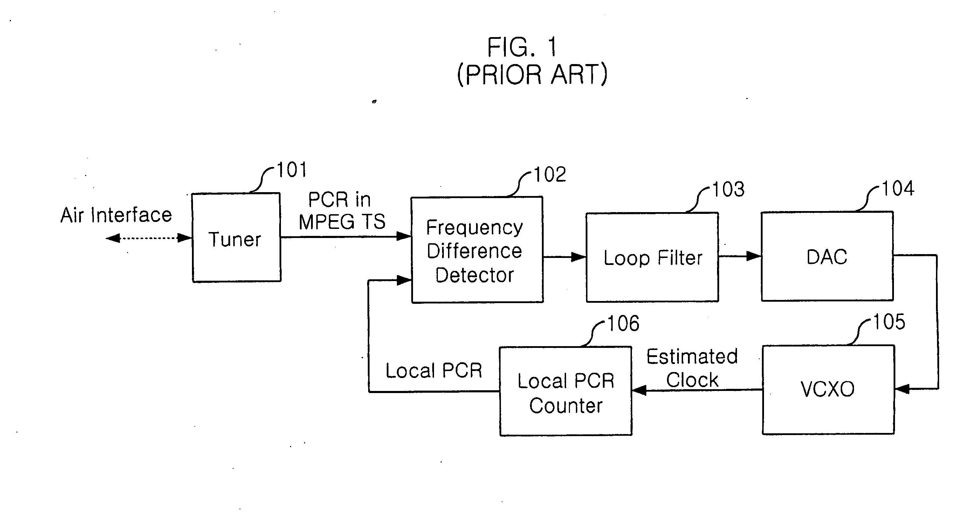

Fig. 1 is a block diagram of a conventional reference clock recovery apparatus.

Referring to Fig. 1, the conventional reference clock recovery apparatus includes a tuner 101, a frequency difference detector 102, a loop filter 103, a digital-to-analog converter (DAC) 104, a voltage controlled crystal oscillator (VCXO) 105, and a local PCR counter 106.

The tuner 101 converts a modulated time division multiplexing (TDM) signal, an IP over MPEG2-TS (DVB MPE) signal or a digital video broadcasting (DVB-S) signal into a digital value.

The frequency difference detector 102 detects a difference in PCR count values of a central station and a terminal by using a PCR inserted in an MPEG-TS and a local clock count value of the terminal and traces a clock frequency of the central station.

The loop filter 103 smoothes the frequency difference between the terminal and the central station. That is, the loop filter 103 smoothes an error value that occurs when the frequency difference calculated by the frequency difference detector is reflected to the VCXO 105.

The DAC 104 converts an output of the loop filter 103 into a predetermined voltage signal. The VCXO 105 outputs a desired frequency based on the voltage signal.

The local PCR counter 106 counts an output clock of the VCXO 105.

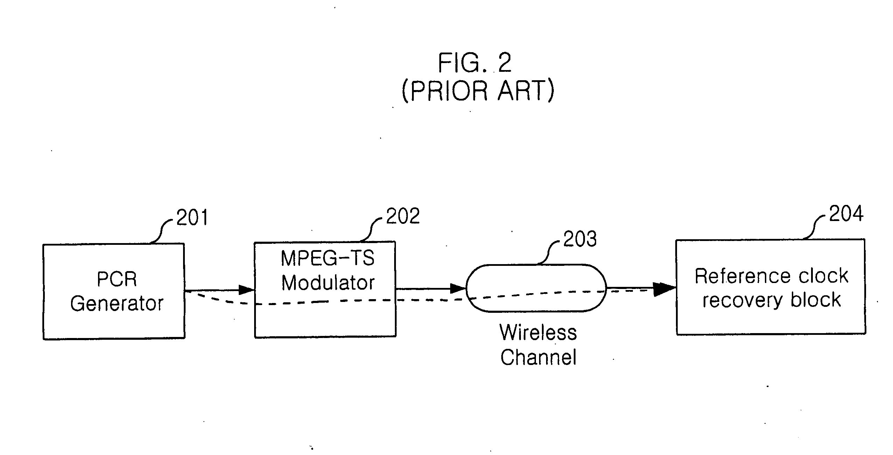

Fig. 2 is a block diagram showing a conventional reference clock recovery method using a time stamp of a forward link.

As shown in Fig. 2, the conventional reference clock recovery method has low accuracy in the forward time stamp and the output timing of the tuner 101, resulting in error. Therefore, it is difficult to accurately recover the network synchronization reference clock.

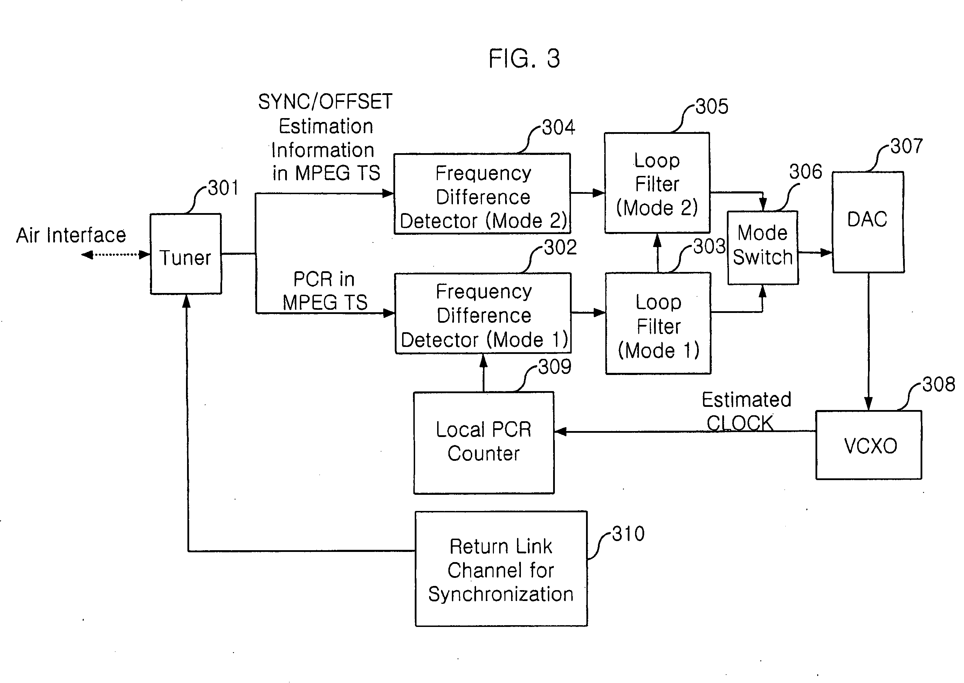

Fig. 3 is a block diagram of a reference clock recovery apparatus in accordance with the present invention.

Referring to Fig. 3, the reference clock recovery apparatus includes a tuner 301, a mode-1 frequency difference detector 302, a mode-1 loop filter 303, a mode-2 frequency difference detector 304, a mode-2 loop filter 305, a mode switch 306, a digital-to-analog converter (DAC) 307, a voltage controlled crystal oscillator (VCXO) 308, a local PCR counter 309, and a return link channel 310.

The tuner 301 receives a signal modulated at the central station through an air interface and converts it into a digital value. The mode-1 frequency difference detector 302 detects a frequency difference between the central station and the terminal by using a PCR value inserted in an MPEG-TS outputted from the tuner 301 and a local clock count value of the terminal and traces a clock frequency of the central station. The mode-1 loop filter 303 smoothes the detected frequency difference between the central station and the terminal. After the synchronization is achieved through the mode-1 frequency difference detector 302, the mode-2 frequency difference detector 304 causes the terminal to maintain a synchronization to the clock of the central station based on a timing estimation information, which is provided from the central station that estimates a timing which the terminal transmits through a return link. A mode-2 loop filter 305 smoothes the frequency difference between the terminal and the central station, which is calculated by the mode-2 frequency difference detector 304. The mode switch 306 selects an operation of the mode-1 frequency difference detector 302 or an operation of the mode-2 frequency difference detector 304. The DAC 307 converts the digital signal from the mode switch 306 into an analog signal of a voltage form. The VCXO 308 receives the voltage from the DAC 307 and outputs a desired frequency. The local PCR counter 309 counts the clocks outputted from the VCXO 308 and outputs the count value to the mode-1 frequency difference detector 302. The return link channel 310 transmits the timing obtained by the mode-1 frequency difference detector 302 through a return link channel for synchronization.

A detailed description about the above-mentioned elements will be made below.

The tuner 301 changes a modulated TDM signal, an IP over MPEG2-TS (DVB MPE) and a DVB-S signal into a digital value.

The mode-1 frequency difference detector 302 detects the frequency difference between the central station and the terminal by using the PCR value inserted in the MPEG-TS and the local clock count value of the terminal and traces the clock frequency of the central station.

The mode-1 loop filter 303 smoothes an error occurring when the detected frequency difference is reflected to the VCXO 308.

Meanwhile, after the synchronization is achieved through the mode-1 frequency difference detector 302, the central station estimates the transport timing of the terminal through the return link and informs the terminal of the timing estimation. The mode-2 frequency difference detector 304 is operated using the synchronization/offset estimation information, such that the terminal maintains the synchronization to the clock of the central station. That is, the mode-2 frequency difference detector 304 is operated based on the information on the timing estimation measured by the central station, in addition to the PCR value in which parameters for adjusting power of the VCXO 308 are inserted in the MPEG-TS.

The mode-2 loop filter 305 smoothes an error occurring when the frequency difference calculated by the mode-2 frequency difference detector 304 is reflected to the VCXO 308.

The mode switch 306 switches the operation of the mode-1 frequency difference detector 302 and the operation of the mode-2 frequency difference detector 304.

The DAC 307 converts an output of the loop filter 303 or 305 selected by the mode switch 306 into a voltage value.

The VCXO 308 receives the output of the DAC 307 and outputs a desired frequency.

The local PCR counter 309 counts an output clock of the VCXO 308 and transmits the local count value to the mode-1 frequency difference detector 302.

The return link channel for synchronization 310 transmits the timing estimation information through the return link channel in order for the clock recovery operating in the mode 2.

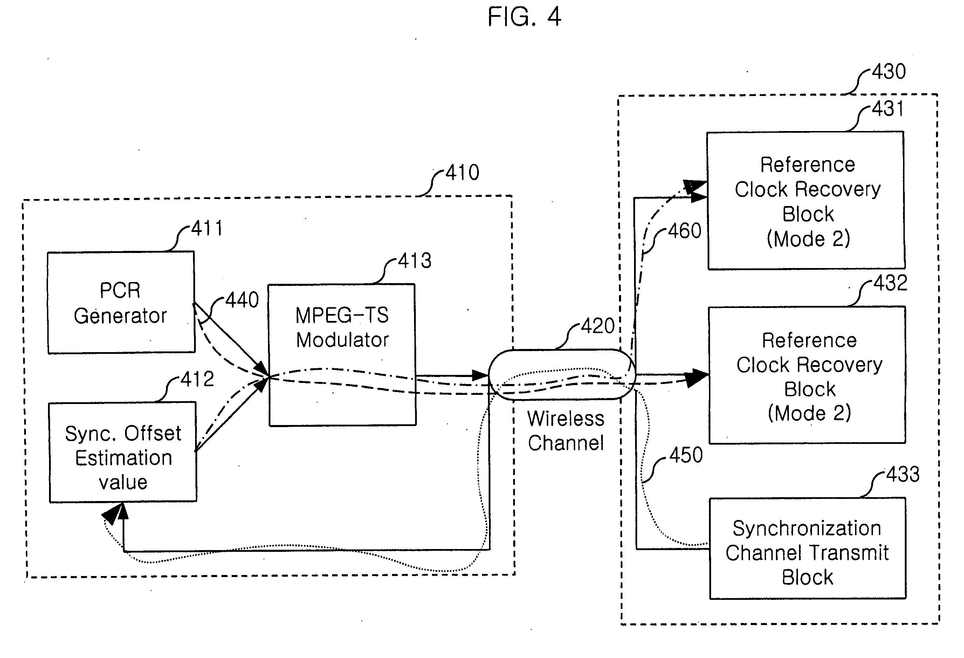

Fig. 4 is a block diagram showing a reference clock recovery method in accordance with an embodiment of the present invention.

Recently, a wireless communication system is changing to a broadband communication system with a high data transmission rate and a resource efficiency is maximized due to the use of the Quasi-synchronization in a code division multiple access (CDMA) system. At this point, the accuracy of the reference clock recovery for the central station and the terminal is an important parameter.

Here, reference numerals 410, 411, 412, 413, 420, 430, 431, 432 and 433 represent the central station, the PCR generator, the synchronization/offset estimation value, the MPEG-TS modulator, the wireless channel, the terminal, the mode-2 reference clock recovery block, the mode-1 reference clock recovery block, and the synchronization channel transmit block, respectively.

First, a dotted line 440 represents an operation of an initial synchronization error compensation mode using the mode-1 reference clock recovery block. The initial synchronization error compensation mode is operated as an open loop obtaining the reference synchronization using the time stamp transmitted through the forward link of the central station 410.

When the initial synchronization error compensation mode is finished, the synchronization maintaining channel is transmitted through the return link indicated by a dotted line 450. Then, the synchronization error estimation information of the central station is again transmitted to the terminal along a dotted line 460, such that the synchronization error compensation mode is operated through the mode-2 frequency difference detector.

A synchronization error compensation mode using the mode-2 frequency difference detector will be described below.

First, several postulations are required.

It is assumed that a reference clock (TCXO) of the central station is R Hz, about 27 MHz and a VCXO of the terminal is T Hz.

A clock having an offset of "n" ppm in the clock of the central station can be estimated using the MPEG-TS. For example, assuming that a frequency difference between the central station and the terminal is "a" when a clock difference between the central station and the terminal is 2 ppm, "a" can be given by Equation 1 below.

$$-54 < a = \frac{T-R}{R} < 54 \qquad \text{(Eq. 1)}$$

The synchronization maintaining channel is transmitted one time when the clock counter of the central station is every 27 M.

If the initial synchronization error compensation mode using the mode-1 frequency difference detector is finished, an input value of the DAC is stored and the mode is changed to the synchronization error compensation mode using the mode-2 frequency difference detector

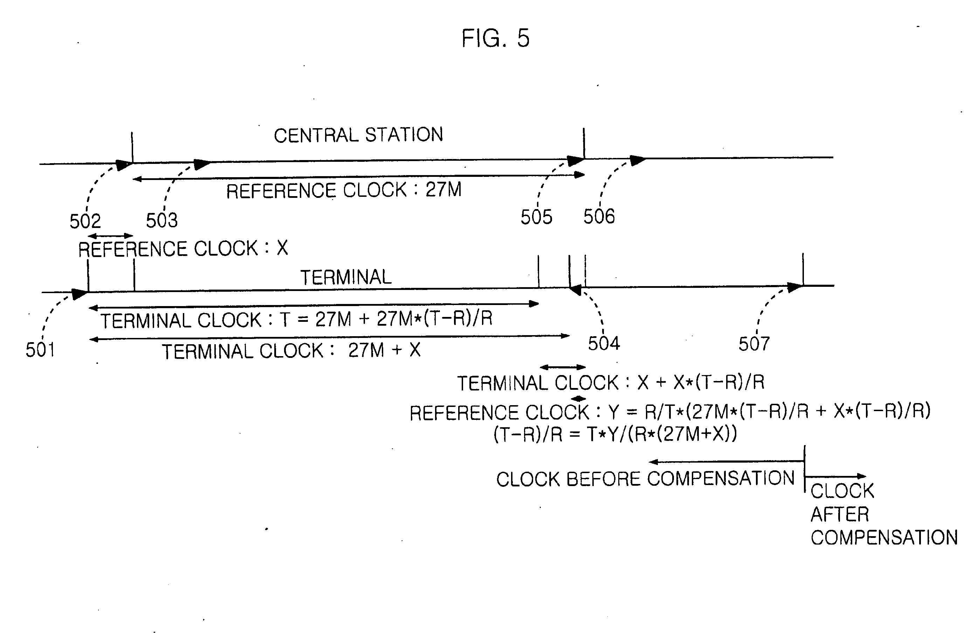

Fig. 5 is a timing diagram showing a synchronization acquisition of the central station and the terminal in the reference clock recovery apparatus in accordance with an embodiment of the present invention.

In Fig. 5, in the case of "X", the central station sends to the terminal a message that X reference clocks are offset in a first synchronization maintaining channel. If the message is transmitted later than a slot timing of the central station, the value is a positive number. On the contrary, if the message is transmitted earlier than the slot timing, the value is a negative number.

In the case of "Y", the central station sends to the terminal a message that Y reference clocks are offset in a second synchronization maintaining channel. If the message is transmitted later than a slot timing of the central station, the value is a positive number. On the contrary, if the message is transmitted earlier than the slot timing, the value is a negative number.

In Fig. 5, "a=T-R" represents a frequency difference between the central station and the terminal and "T" is equal to "R+a". Also, "(T-R)/R" represents a difference of frequency ppm between the central station and the terminal.

Next, a method for maintaining the synchronization in the synchronization error compensation mode using the mode-2 frequency difference detector will be described below.

First, in step 501, the terminal transmits the synchronization maintaining channel to the central station as fast as X clocks as the clock of the central station. That is, although the terminal transmits the synchronization maintaining channel at an allocated time, the synchronization with the central station is mismatched and therefore the synchronization maintaining channel is transmitted as the clock of the central station at a timing as fast as X clocks.

Then, in step 502, the central station receives the synchronization maintaining channel as fast as X clocks as the clock of the central station. That is, it is estimated that the central station receives the synchronization maintaining channel as late as X clocks as the clock of the central station.

In step 503, as a result of estimating the timing offset at the central station, it is estimated that the terminal sends the channel as fast as X clocks as the clock of the central station. The central station transmits the result to the terminal as the synchronization error compensation information between the synchronization channels.

Then, in step 504, the terminal receives an instruction of sensing the channel as fast as the X clocks and transmits the synchronization maintaining channel as the clock of the terminal after the X clocks at a next transmission timing.

The central station estimates that the timing when the terminal transmits the synchronization maintaining channel is spaced apart by the Y clocks as the clock of the terminal from the timing (505) considered correct by the central station and by the Y clocks as the clock of the central station.

Then, in step 506, the central station informs the terminal that the Y clocks are offset.

In step 507, the terminal calculates the frequency difference "a" between the terminal and the central station, controls the VCXO through the loop filter by using the frequency difference "a", and transmits the synchronization maintaining channel as slow as the Y clocks.

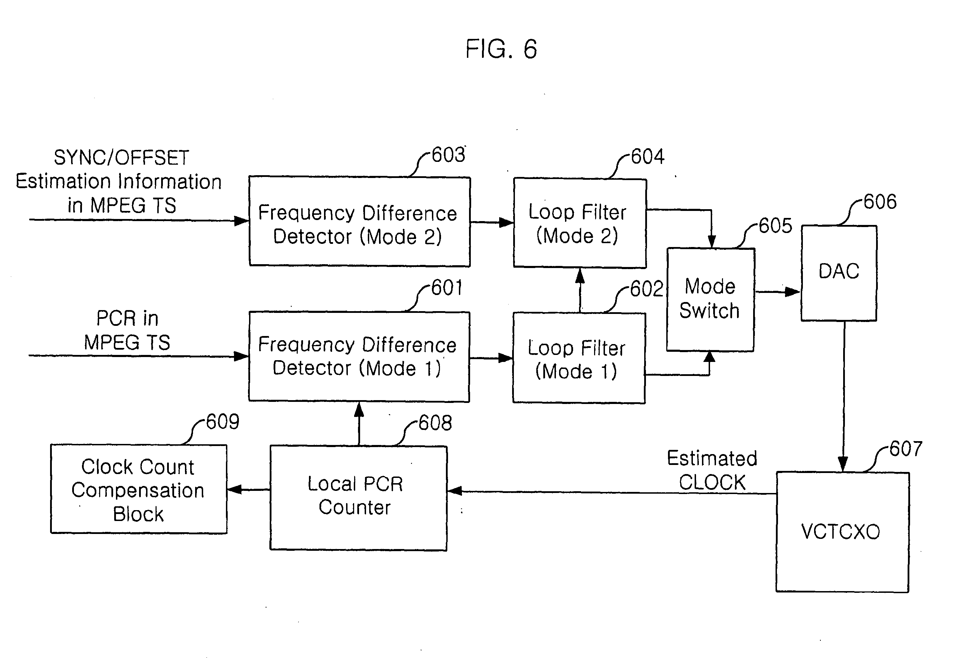

In Fig. 5, there occurs a difference between the timing "504" and the timing "507" at a time point when the clock of the terminal must be compensated. This may cause an error when counting a clock for calculating a timing of a next synchronization maintaining transmission. Therefore, a block for compensating for the error is required. In Fig. 6, there is shown a clock count compensation block.

Meanwhile, the difference between the timings 505 and 504, that is, the reference clock count value "Y" of the central station, is given by Equation 2 below.

$$Y = \frac{R}{T} \times \left(27M \times \frac{T-R}{R} + X \times \frac{T-R}{R}\right) \qquad \text{(Eq. 2)}$$

Since T-R=a and T=R+a, Equation 2 can be rewritten as follows:

$$Y = \frac{R}{T} \times (27M \times \frac{T-R}{R} + X \times \frac{T-R}{R}) = \frac{(27M + X) \times a}{R + a} \quad \text{(Eq. 3)}$$

$$a = \frac{R \times Y}{K + X - Y} \cong \frac{27M \times Y}{K + X - Y} \quad \text{(Eq. 4)}$$

Meanwhile, "X" and "Y" is a known information contained in the synchronization error information transmitted from the central station to the terminal. Since "R" is a value much greater than "X" and "Y" and close to 27,000,000, "R" can be approximated to 27,000,000.

Therefore, "a" representing the frequency difference between the central station and the terminal can be approximated in that manner. In some cases, "X" and "Y" are values much smaller than 27,000,000, and thus "a" can be approximated to "Y".

The above Equation is calculated on the assumption that the transmission period of the synchronization maintaining channel is 27M of the clock of the central station. The above Equation can be generalized as Equation 4 below without regard to the transmission period of the synchronization maintaining channel.

$$a = \frac{R \times Y}{K + X - Y} \cong \frac{27M \times Y}{K + X - Y} \quad \text{(Eq. 4)}$$

where K represents the transmission period of the synchronization maintaining channel, that is, the clock count value of the central station.

Fig. 6 is a block diagram of a reference clock recovery apparatus in accordance with another embodiment of the present invention.

Referring to Fig. 6, the reference clock recovery apparatus includes a mode-1 frequency difference detector 601, a mode-1 loop filter 602, a mode-2 frequency difference detector 603, a mode-2 loop filter 604, a mode switch 605, a digital-to-analog converter (DAC) 606, a voltage controlled temperature-compensated crystal oscillator (VCTCXO) 607, a local PCR counter 608, and a clock count compensation block 609.

The mode-1 frequency difference detector 601 detects a frequency difference between the central station and the terminal by using a PCR value inserted in an inputted MPEG-TS and a local clock count value of the terminal and traces a clock frequency of the central station. The mode-1 loop filter 602 smoothes the detected frequency difference between the central station and the terminal. After the synchronization is achieved through the mode-1 frequency difference detector 601, the mode-2 frequency difference detector 603 causes the terminal to maintain a synchronization to the clock of the central station based on a timing estimation information, which is provided from the central station that estimates a timing which the terminal transmits through a return link. A mode-2 loop filter 604 smoothes the frequency difference between the terminal and the central station, which is calculated by the mode-2 frequency difference detector 603. The mode switch 605 selects an operation of the mode-1 frequency difference detector 601 or an operation of the mode-2 frequency difference detector 603. The DAC 606 converts the digital signal from the mode switch 605 into an analog signal of a voltage form. The VCTCXO 607 receives the voltage from the DAC 606 and outputs a desired frequency. The local PCR counter 608 counts the clocks outputted from the VCTCXO 607 and outputs the count value to the mode-1 frequency difference detector 601. The clock count compensation block 609 compensates for an error occurring when the timing of the synchronization maintaining transmission is calculated.

While the reference clock recovery apparatus of Fig. 6 is similar to that of Fig. 3, the clock count compensation block 609 is further included for synchronization acquisition and maintaining function of the terminal. That is, the clock count compensation block 609 compensates for an error occurring when the clocks are counted in calculating a next synchronization maintaining transmission timing.

In addition, the VCTCXO 607 can be used instead of the VCXO 308 shown in Fig. 3.

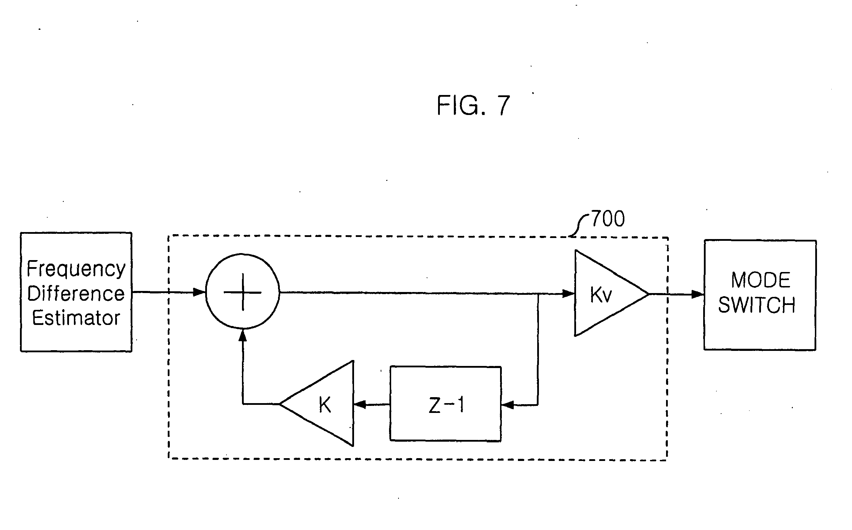

Fig. 7 is a detailed diagram of the loop filter in accordance with an embodiment of the present invention.

A loop filter 700 is provided in each of two modes of the reference clock recovery apparatus in accordance with the present invention. The loop filter can be provided in various forms.

In Fig. 7, a first order IIR filter 700 is exemplarily shown.

If a sequence of the estimated values of a frequency difference between the central station and the terminal is a(0), a(1), a(2),..., a(N),..., an output Z(N) of the loop filter is given by Equation 5 below.

$$Z(n) = Kv \times (a(n) + k \times Z(n-1)) \qquad \text{(Eq. 5)}$$

That is, the VCXO can be controlled by adjusting coefficient of the first order IIR filter 700.

The above-mentioned method in accordance with the present invention can be implemented with a computer-readable recording medium (for example, RAM, ROM, floppy disk, hard disk, optical magnetic disk, etc.).

As described above, the terminal can accurately acquire and maintain the reference clock recovery in a satellite communication system or a wireless communication system, which requires the accurate reference clock recovery.

The present application contains subject matter related to Korean patent application No. 2003-98302, filed in the Korean Intellectual Property Office on December 27, 2003.

While the present invention has been described with respect to the particular embodiments, it will be apparent to those skilled in the art that various changes and modifications may be made without departing from scope of the invention as defined in the following claims.

## Claims

**1.** A reference clock recovery apparatus comprising:

a first frequency difference detecting unit (302; 601) for detecting a frequency difference using a received PCR-value of a central station and a local PCR-value of a terminal;
a first filtering unit (303; 602) for smoothing the detected frequency difference;
a second frequency difference detecting unit(304; 603) for maintaining a synchronization of the terminal to the clock of the central station based on timing estimation information received from the central station which is based on timing information sent from the terminal to the central station through a return link channel for synchronisation;
**characterized by**:

a second filtering unit connected to the output of the first filtering unit and the output of the second frequency difference detecting unit (305; 604) for smoothing the frequency difference between the terminal and the central station;
a switching unit (306; 605) for selecting an output of one of the first filtering unit (303; 602) and the second filtering unit (305; 604) ;

an oscillating unit (308; 607) for receiving an output of the switching unit (306; 605) and outputting a desired frequency; and
a counting unit(309; 608) for counting the clocks outputted from the oscillating unit (308; 607) and outputting the count value to the first frequency difference detecting unit(302; 601).

**2.** The reference clock recovery apparatus of claim 1 further comprising:

a digital-to-analog converting unit (307; 606) for converting a digital signal from the switching unit (306; 605) into an analog signal; and
a compensating unit (609) for compensating for an error occurring when a next synchronization maintaining transmission timing of the terminal is calculated.

**3.** The reference clock recovery apparatus of any one of claims 1 or 2, wherein the first frequency difference detecting (302; 601) detects the frequency difference between the central station and the terminal based on a program clock reference value and a local clock count value of the terminal, and traces the clock frequency of the central station.

**4.** The reference clock recovery apparatus of any one of claims 1 or 2, wherein the timing estimation information is provided from the central station that estimates a timing which the terminal transmits through the return link channel for synchronization.

5. The reference clock recovery apparatus of any one of claims 1 or 2, wherein the oscillating unit (308; 607) is a voltage-controlled crystal oscillator or a voltage-controlled temperature-compensated crystal oscillator.

6. A reference clock recovery method applied to a reference clock recovery apparatus, comprising the steps of:

acquiring a reference synchronization by compensating an initial synchronization error based on a received and a local PCR-value;
estimating timing information transmitted from a terminal through a return link channel for synchronization and generating timing estimation information;
maintaining a synchronization of the terminal to the clock of the central station based on the timing estimation information which is received from a central station
selecting one of the acquired reference synchronization and the synchronization of the terminal which is maintained to the clock of the central station; and
receiving the selected synchronization and outputting a desired frequency.

## Patentansprüche

1. Referenztakt-Wiedergewinnungsvorrichtung, die umfasst:

eine erste Frequenzdifferenz-Detektionseinheit (302; 601) zum Detektieren einer Frequenzdifferenz unter Verwendung eines empfangenen PCR-Wertes einer Zentralstation und eines lokalen PCR-Wertes eines Endgeräts;
eine erste Filtereinheit (303; 602) zum Glätten der detektierten Frequenzdifferenz;
eine zweite Frequenzdifferenz-Detektionseinheit (304; 603) zum Aufrechterhalten einer Synchronisation des Endgeräts mit dem Takt der Zentralstation auf der Grundlage von Zeitgabeschätzinformationen, die von der Zentralstation empfangen werden und die auf Zeitgabeinformationen basieren, die von dem Endgerät über einen Rückwärtsstreckenkanal für die Synchronisation zu der Zentralstation geschickt werden;
**gekennzeichnet durch**:

eine zweite Filtereinheit (305; 604), die mit dem Ausgang der ersten Filtereinheit und mit dem Ausgang der zweiten Frequenzdifferenz-Detektionseinheit verbunden ist, um die Frequenzdifferenz zwischen dem Endgerät und der Zentralstation zu glätten;
eine Schalteinheit (306; 605) zum Wählen eines Ausgangs entweder der ersten Filtereinheit (303; 602) oder der zweiten Filtereinheit (305; 604);
eine Oszillationseinheit (308; 607) zum Empfangen eines Ausgangssignals der Schalteinheit (306; 605) und zum Ausgeben einer gewünschten Frequenz; und
eine Zähleinheit (309; 608) zum Zählen der von der Oszillationseinheit (308; 607) ausgegebenen Takte und zum Ausgeben des Zählwerts zu der ersten Frequenzdifferenz-Detektionseinheit (302; 601).

2. Referenztakt-Wiedergewinnungsvorrichtung nach Anspruch 1, die ferner umfasst:

eine Digital/Analog-Umsetzungseinheit (307; 606) zum Umsetzen eines digitalen Signals von der Schalteinheit (306; 605) in ein analoges Signal; und
eine Kompensationseinheit (609) zum Kompensieren eines Fehlers, der auftritt, wenn eine nächste Synchronisationsaufrechterhaltungs-Übertragungszeitgabe des Endgeräts berechnet wird.

3. Referenztakt-Wiedergewinnungsvorrichtung nach einem der Ansprüche 1 oder 2, wobei die erste Frequenzdifferenz-Detektionseinheit (302; 601) die Frequenzdifferenz zwischen der Zentralstation und dem Endgerät auf der Grundlage eines Programmtakt-Referenzwertes und eines lokalen Taktzählwertes des Endgeräts detektiert und die Taktfrequenz der Zentralstation verfolgt.

4. Referenztakt-Wiedergewinnungsvorrichtung nach einem der Ansprüche 1 oder 2, wobei die Zeitgabeschätzinformationen von der Zentralstation bereitgestellt werden, die eine Zeitgabe schätzt, die das Endgerät über den Rückwärtsstreckenkanal für die Synchronisation sendet.

5. Referenztakt-Wiedergewinnungsvorrichtung nach einem der Ansprüche 1 oder 2, wobei die Oszillationseinheit (308;

607) ein spannungsgesteuerter Kristalloszillator oder eine spannungsgesteuerter, temperaturkompensierter Kristalloszillator ist.

**6.** Referenztakt-Wiedergewinnungsverfahren, das auf eine Referenztakt-Wiedergewinnungsvorrichtung angewendet wird und die folgenden Schritte umfasst:

Ermitteln einer Referenzsynchronisation durch Kompensieren eines anfänglichen Synchronisationsfehlers auf der Grundlage eines empfangenen und eines lokalen PCR-Wertes;
Schätzen von Zeitgabeinformationen, die von einem Endgerät über einen Rückwärtsstreckenkanal für die Synchronisation gesendet werden, und Erzeugen von Zeitgabeschätzinformationen;
Aufrechterhalten einer Synchronisation des Endgeräts mit dem Takt der Zentralstation auf der Grundlage der Zeitgabeschätzinformationen, die von einer Zentralstation empfangen werden;
Auswählen der ermittelten Referenzsynchronisation oder der Synchronisation des Endgeräts, die auf dem Takt der Zentralstation gehalten wird; und
Empfangen der ausgewählten Synchronisation und Ausgeben einer gewünschten Frequenz.

## Revendications

**1.** Appareil de récupération d'horloge de référence comprenant :

une première unité de détection de différence de fréquences (302 ; 601) pour détecter une différence de fréquences en utilisant une valeur PCR reçue d'une station centrale et une valeur PCR locale d'un terminal ;
une première unité de filtrage (303 ; 602) pour lisser la différence de fréquences détectée ;
une deuxième unité de détection de différence de fréquences (304 ; 603) pour maintenir une synchronisation du terminal avec l'horloge de la station centrale sur la base d'informations d'estimation de timing reçues de la station centrale qui sont basées sur des informations de timing envoyées du terminal à la station centrale par le biais d'un canal de liaison de retour pour la synchronisation ;
**caractérisé par** :

une seconde unité de filtrage connectée à la sortie de la première unité de filtrage et à la sortie de la seconde unité de détection de différence de fréquences (305 ; 604) pour lisser la différence de fréquences entre le terminal et la station centrale ;
une unité de commutation (306 ; 605) pour sélectionner une sortie de l'une de la première unité de filtrage (303 ; 602) et de la seconde unité de filtrage (305 ; 604) ;
une unité d'oscillation (308 ; 607) pour recevoir une sortie de l'unité de commutation (306 ; 605) et délivrer une fréquence souhaitée ; et
une unité de comptage (309 ; 608) pour compter les horloges délivrées de l'unité d'oscillation (308 ; 607) et délivrer la valeur de compte à la première unité de détection de différence de fréquences (302 ; 601).

**2.** Appareil de récupération d'horloge de référence selon la revendication 1, comprenant en outre :

une unité de conversion numérique-analogique (307 ; 606) pour convertir un signal numérique de l'unité de commutation (306 ; 605) en un signal analogique ; et
une unité de compensation (609) pour compenser une erreur survenant lorsqu'un prochain timing de transmission de maintien de synchronisation du terminal est calculé.

**3.** Appareil de récupération d'horloge de référence selon l'une quelconque des revendications 1 ou 2, dans lequel la première unité de détection de différence de fréquences (302 ; 601) détecte la différence de fréquences entre la station centrale et le terminal sur la base d'une valeur de référence d'horloge de programme et d'une valeur de compte d'horloge locale du terminal, et suit la fréquence d'horloge de la station centrale.

**4.** Appareil de récupération d'horloge de référence selon l'une quelconque des revendications 1 ou 2, dans lequel les informations d'estimation de timing sont fournies depuis la station centrale qui estime un timing que le terminal transmet par le biais du canal de liaison de retour pour la synchronisation.

**5.** Appareil de récupération d'horloge de référence selon l'une quelconque des revendications 1 ou 2, dans lequel l'unité d'oscillation (308 ; 607) est un oscillateur de cristal commandé en tension ou un oscillateur de cristal à compensation de température et commandé en tension.

6. Procédé de récupération d'horloge de référence appliqué à un appareil de récupération d'horloge de référence, comprenant les étapes consistant à :

acquérir une synchronisation de référence en compensant une erreur de synchronisation initiale sur la base d'une valeur PCR reçue et d'une valeur PCR locale ;
estimer des informations de timing transmises depuis un terminal par le biais d'un canal de liaison de retour pour la synchronisation et générer des informations d'estimation de timing ;
maintenir une synchronisation du terminal avec l'horloge de la station centrale sur la base des informations d'estimation de timing qui sont reçues d'une station centrale ;
sélectionner l'une de la synchronisation de référence acquise et de la synchronisation du terminal qui est maintenue avec l'horloge de la station centrale ; et
recevoir la synchronisation sélectionnée et délivrer une fréquence souhaitée.

Air Interface
Tuner
101
PCR in MPEG TS
Frequency Difference Detector
102
Loop Filter
103
DAC
104
VCXO
105
Estimated Clock
Local PCR Counter
106
Local PCR

FIG. 1
(PRIOR ART)

FIG. 2
(PRIOR ART)

201
PCR Generator
202
MPEG-TS Modulator
203
Wireless Channel
204
Reference clock recovery block

FIG. 3

SYNC/OFFSET Estimation Information in MPEG TS
304
Frequency Difference Detector (Mode 2)
305
Loop Filter (Mode 2)
307
306
DAC
Mode Switch
301
Air Interface
Tuner
PCR in MPEG TS
302
Frequency Difference Detector (Mode 1)
303
Loop Filter (Mode 1)
309
308
Estimated CLOCK
Local PCR Counter
VCXO
Return Link Channel for Synchronization
310

FIG. 4
410
411
PCR Generator
440
413
MPEG-TS Modulator
412
Sync. Offset Estimation value
420
Wireless Channel
430
431
Reference Clock Recovery Block (Mode 2)
460
432
Reference Clock Recovery Block (Mode 2)
450
433
Synchronization Channel Transmit Block

FIG. 5

CENTRAL STATION
TERMINAL
REFERENCE CLOCK : 27M
REFERENCE CLOCK : X
TERMINAL CLOCK : T = 27M + 27M*(T−R)/R
TERMINAL CLOCK : 27M + X
TERMINAL CLOCK : X + X*(T−R)/R
REFERENCE CLOCK : Y = R/T*(27M*(T−R)/R + X*(T−R)/R)
(T−R)/R = T*Y/(R*(27M+X))
CLOCK BEFORE COMPENSATION
CLOCK AFTER COMPENSATION
501
502
503
504
505
506
507

FIG. 6

SYNC/OFFSET
Estimation Information
in MPEG TS
PCR in
MPEG TS
603
Frequency Difference
Detector (Mode 2)
601
Frequency Difference
Detector (Mode 1)
604
Loop Filter
(Mode 2)
602
Loop Filter
(Mode 1)
605
Mode
Switch
606
DAC
607
VCTCXO
Estimated
CLOCK
608
Local PCR
Counter
609
Clock Count
Compensation
Block

MODE SWITCH
700
Kv
Z-1
K
Frequency Difference Estimator

FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20030066094 A
- KR 200398302